# EUROPÄISCHE PATENTSCHRIFT

(11) **EP 1 149 292 B1**
(45) Veröffentlichungstag und Bekanntmachung des Hinweises auf die Patenterteilung: **08.10.2003**
(21) Anmeldenummer: 00956516.9
(22) Anmeldetag: 05.09.2000
(51) Int. Cl.: G01R 31/04

(54) **EINRICHTUNG ZUM TESTEN VON MIT STECKERN VERSEHENEN KABELN**
DEVICE FOR TESTING CABLES THAT ARE PROVIDED WITH PLUG CONNECTORS
DISPOSITIF PERMETTANT DE TESTER DES CABLES DOTES DE FICHES

(30) Priorität: 17.11.1999 DE 29920214 U
(43) Veröffentlichungstag der Anmeldung: 31.10.2001
(73) Patentinhaber: TSK Prüfsysteme für elektrische Komponenten GmbH, 32457 Porta Westfalica (DE)
(72) Erfinder: STENGEL, Jürgen, 31707 Heessen (DE)
(74) Vertreter: Bremer, Ulrich
(86) Internationale Anmeldenummer: EP0008637
(87) Internationale Veröffentlichungsnummer: WO01036991

(56) Entgegenhaltungen:
- DE-A- 19 500 113
- DE-U- 29 817 517
- US-A- 4 218 745

## Beschreibung

Die vorliegende Erfindung betrifft eine Einrichtung zum Testen von mit Steckern versehenen Kabeln, mit einer Vielzahl von Adaptern, die jeweils mit einer einem bestimmten Stecker zugeordneten Steckeraufnahme versehen sind, einer Meßtechnik, einem Rechner zur Auswertung der durch die Meßtechnik ermittelten Daten, einem Speicher zur Aufnahme stecker-bzw. adapterspezifischer Daten und einem PC, an den ein Monitor angeschlossen ist.

Mittels solcher Einrichtungen werden Kabel auf Durchgängigkeit sowie daran angeschlossene Stecker auf korrekte Verrastung geprüft. Solche mit Steckern bestückte Kabel finden beispielsweise im Automobilbau Verwendung, wobei mit Hilfe der Einrichtung vor allem Kabel getestet werden, die zu Kabelbäumen zusammengefaßt sind, das heißt, es erfolgt eine Überprüfung einer Vielzahl von Kabeln gleichzeitig.

Jeder Adapter weist eine Steckeraufnahme auf, die in ihrer Konfiguration an einen bestimmten Stecker angepaßt ist, so daß nur dieser eine Stecker in die entsprechende Steckeraufnahme eingesteckt werden kann.
Da an jedem Kabelende ein Stecker angeschlossen ist, sind für jedes Kabel entsprechend zwei Adapter erforderlich.

Bei den bekannten Einrichtungen sind sämtliche Adapter an einen gemeinsamen Speicher angeschlossen, in den die jeweiligen steckerspezifischen Angaben manuell eingegeben werden müssen. Gerade bei der Vielzahl der gleichzeitig zu testenden Kabel, die eine entsprechende Anzahl von Adaptern erforderlich machen, ist eine solche manuelle Eingabe sehr aufwendig und zeitintensiv. Auch der Austausch von Adaptern, beispielsweise zum Testen von neuen Steckern, ist in der Handhabung aufwendig und nicht geeignet für eine Optimierung des gesamten Testverfahrens, wobei in jedem Fall die neuen steckerspezifischen Daten eingegeben werden müssen. Naturgemäß ist die Fehlerhäufigkeit einer manuellen Eingabe, insbesondere bei der Vielzahl der Stecker, relativ groß, so daß eine Gewähr für die einwandfreie Überprüfung der Kabel bzw. Stecker nicht gegeben ist.

Ebenfalls für alle Adapter gemeinsam ist bisher eine Meßtechnik vorgesehen, wodurch jedoch eine aufwendige elektrische Verbindung zu den einzelnen Adaptern erforderlich ist. Zu deren Aufnahme wird eine sogenannte Matrix verwandt, die sozusagen einen Sockel bildet, an dem die einzelnen Adapter angeschlossen sind. Zum einen ist hierdurch der Fertigungsaufwand relativ hoch, zum anderen ist die weitere Bestückung mit zusätzlichen Adaptern problematisch und nur mit einem erheblichen baulichen Aufwand realisierbar.

DE 195 00 113 offenbart einen einer Halbleiterspeicher aufweisenden Adapter zum Testen von Kabelbäumen. Der Halbleiterspeicher dient zum Ablegen adapterspezifischer Daten. Mehrere Adapter werden in einen Kabellegetisch eingebaut und mit einem zentralen Rechner verbunden.

Der vorliegenden Erfindung liegt daher die Aufgabe zugrunde, eine Einrichtung der gattungsgemäßen Art so auszubilden, daß sie konstruktiv einfacher aufgebaut, ihre Handhabung optimiert und ihre Verwendungsfähigkeit verbessert wird.

Diese Aufgabe wird durch eine Einrichtung gelöst, die die Merkmale des Anspruchs 1 aufweist.

Durch diese konstruktive Ausgestaltung, bei der jedem Adapter eine eigene Meßtechnik, ein Rechner sowie ein Speicher zugeordnet ist, sind alle relevanten Daten sofort abrufbar, ohne daß eine manuelle Eingabe der steckerspezifischen Daten direkt am Prüftisch erfolgen muß. Vielmehr werden diese Daten werkseitig bei der Herstellung bzw. Aufrüstung des Adapters eingegeben. Dies gilt gleichermaßen für alle drei genannten Komponenten, wobei diese zweckmäßigerweise in einer gemeinsamen Baueinheit integriert sind, mit der der Adapter verbunden wird.

Diese Baueinheit wiederum ist an einen Bus angeschlossen, der mit dem PC verbunden ist, über dessen angeschlossenen Monitor die ermittelten Daten angezeigt werden.

Grundsätzlich können an den Bus beliebig viele Baueinheiten und somit beliebig viele Adapter angeschlossen werden, wodurch sich die Verwendungsfähigkeit der gesamten Einrichtung wesentlich verbessert.

Durch die Quasi-Integration der für die Testung des Kabels notwendigen Komponenten in dem Adapter werden überdies sowohl die Handhabung vereinfacht, als auch mögliche Fehlerursachen durch falsche Bedienung ausgeschlossen, zumindest aber minimiert.

Nach einer vorteilhaften Ausbildung der Erfindung ist vorgesehen, den Speicher direkt in dem Adapter zu integrieren, wodurch sich die Herstellung noch weiter vereinfachen läßt.

Weitere vorteilhafte Ausbildungen der Erfindung sind in den Unteransprüchen gekennzeichnet.

Ein Ausführungsbeispiel der Erfindung wird nachfolgend anhand der beigefügten Zeichnungen beschrieben.

Es zeigen:
- **Figur 1**: eine erfindungsgemäße Einrichtung in einer schematischen Darstellung
- **Figur 2**: einen Teil der Einrichtung gleichfalls in einer schematischen Ansicht.

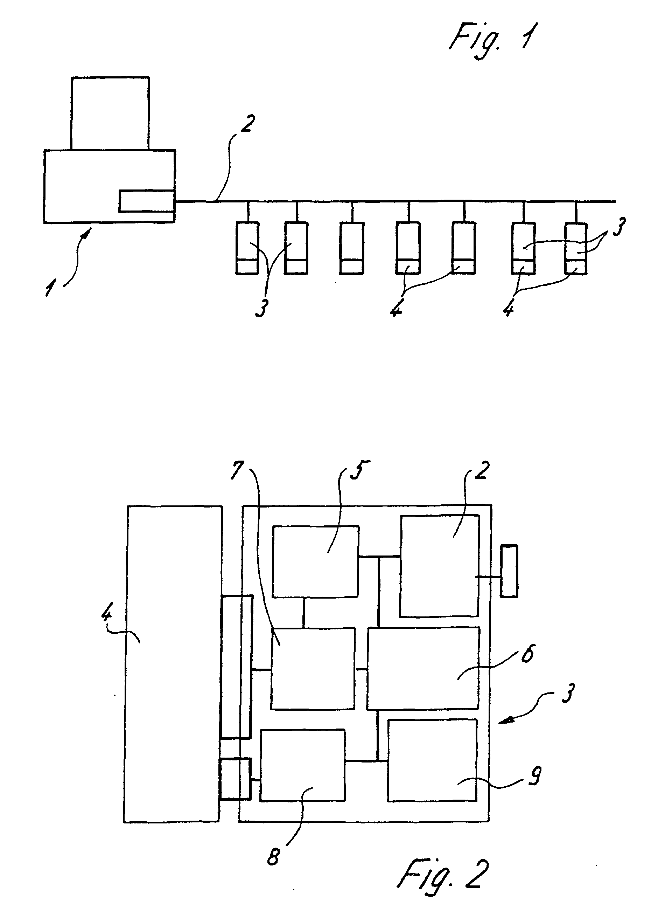

In der Figur 1 ist eine Einrichtung zum Testen von mit Steckern versehenen Kabeln dargestellt, die eine Vielzahl von Adaptern 4 aufweist, an die jeweils eine Baueinheit 3 angeschlossen ist, in der jedem Adapter 4 zugeordnet eine Meßtechnik 5, ein Bus-Controller mit Rechner 6, eine Testpunktelektronik 7, ein digitales Interface 8 sowie ein Speicher 9 angeordnet sind (Figur 2).

Jede Baueinheit 3 ist an einen Bus 2 angeschlossen, über den auch eine Stromversorgung erfolgt.

Der Bus 2 ist mit einem einen Monitor aufweisenden PC 1 verbunden, der eine zentrale Schnittstelle bildet und über den die Prüfergebnisse angezeigt werden.

Das digitale Interface 8 ist im Bedarfsfall vorzusehen, wobei es zur Steuerung des Adapters bei Sonderfunktionen dient, beispielsweise zur Steuerung von Pneumatikventilen, mit denen im Adapter angeordnete Verriegelungseinrichtungen betätigbar sind.

In an sich bekannter Weise sind in dem Adapter 4 Prüfnadeln und/oder ähnliche, für die Durchgängigkeit des Kabels bzw. die Verrastungsprüfung des Steckers notwendige Bauteile vorgesehen.

## Patentansprüche

1. Einrichtung zum Testen von mit Steckern versehenen Kabeln, mit
einer Vielzahl von Adaptern (4), die jeweils mit einer einem bestimmten Stecker zugeordneten Steckeraufnahme versehen sind,
einem PC (1), an den ein Monitor angeschlossen ist,
wobei jedem Adapter (4),
eine eigene Meßtechnik (5),
ein eigener Rechner (6) zur Auswertung der durch die Messtechnik ermittelten Daten,
ein eigener Speicher (9) zur Aufnahme stecker- bzw, adapterspezifischer Daten sowie
eine eigene Testpunktelektronik (7) zugeordnet sind, die über einen Bus (2) mit dem PC (1) verbunden sind.

2. Einrichtung nach Anspruch 1, **dadurch gekennzeichnet, daß** die Meßtechnik (5), der Rechner (6), der Speicher (9) und die Testpunktelektronik in einer Baueinheit (3) zusammengefaßt sind.

3. Einrichtung nach Anspruch 1, **dadurch gekennzeichnet, daß** der Speicher (9) in den Adapter (4) integriert ist.

4. Einrichtung nach Anspruch 1, **dadurch gekennzeichnet, daß** jedem Adapter (4) ein digitales Interface (8) zur Steuerung des Adapters bei Sonderfunktionen zugeordnet ist.

5. Einrichtung nach Anspruch 2, **dadurch gekennzeichnet, daß** eine Stromversorgung der Baueinheit (3) über den Bus (2) erfolgt.

## Claims

1. A device for testing cables which are fitted with plugs, having a large number of adapters (4) each of which is fitted with a plug receptacle assigned to a specific plug, a PC (1), to which a monitor is connected, and assigned to each adaptor is its own measuring equipment (5), its own computer (6) for evaluating the data determined by the measuring equipment, its own memory (9) to take data specific to a plug and/or adaptor and its own test point electronics (7), which are connected to the PC (1) through a bus (2).

2. A device in accordance with Claim 1 **characterised by** the fact that the measurement equipment (5), the computer (6), the memory (9) and the test point electronics are combined in one assembly unit (3).

3. A device in accordance with Claim 1 **characterised by** the fact that the memory (9) is integrated into the adaptor (4).

4. A device in accordance with Claim 1 **characterised by** the fact that assigned to each adaptor (4) there is a digital interface (8) for control of the adaptor for special functions.

5. A device in accordance with Claim 2 **characterised by** the fact that a power supply for the assembly unit (3) is provided through the bus (2).

## Revendications

1. Dispositif servant à tester des câbles pourvus de connecteurs, avec une multitude d'adaptateurs (4) respectivement pourvus d'un logement associé à une fiche déterminée, un ordinateur personnel (1), auquel est raccordé un écran, à chaque adaptateur (4) étant associé son propre matériel de mesure (5), son propre calculateur (6) pour l'évaluation des données déterminées par le matériel de mesure, sa propre mémoire (9) pour stocker des données spécifiques du connecteur ou de l'adaptateur, ainsi que sa propre électronique de point de contrôle (7), qui sont reliés à l'ordinateur personnel (1) par l'intermédiaire d'un bus (2).

2. Dispositif suivant la revendication 1, **caractérisé en ce que**, le matériel de mesure (5), le calculateur (6), la mémoire (9) et l'électronique de point de contrôle sont regroupés dans une unité modulaire (3).

3. Dispositif suivant la revendication 1, **caractérisé en ce que** la mémoire (9) est intégrée dans l'adaptateur (4).

4. Dispositif suivant la revendication 1, **caractérisé en ce qu**'à chaque adaptateur (4) est associée une interface numérique (8) pour la commande de l'adaptateur en cas de fonctions spéciales.

5. Dispositif suivant la revendication 2, **caractérisé en ce qu**'une alimentation en courant de l'unité modulaire (3) a lieu par l'intermédiaire du bus (2).
